# EUROPÄISCHE PATENTSCHRIFT

(11) **EP 2 220 521 B1**
(45) Veröffentlichungstag und Bekanntmachung des Hinweises auf die Patenterteilung: **10.01.2018**
(21) Anmeldenummer: 08859060.9
(22) Anmeldetag: 12.11.2008
(51) Int. Cl.: G02B 5/04, H01L 51/52

(54) **LICHTEMITTIERENDE VORRICHTUNG**
LIGHT-EMITTING DEVICE
DISPOSITIF ÉMETTEUR DE LUMIÈRE

(30) Priorität: 12.12.2007 DE 102007059732
(43) Veröffentlichungstag der Anmeldung: 25.08.2010
(73) Patentinhaber: OSRAM OLED GmbH, 93049 Regensburg (DE)
(72) Erfinder: KRUMMACHER, Benjamin, Claus, 93057 Regensburg (DE); SCHINDLER, Florian, 83278 Traunstein (DE); KLEIN, Markus, 93105 Tegernheim (DE)
(74) Vertreter: Epping - Hermann - Fischer
(86) Internationale Anmeldenummer: PCT/DE2008/001868
(87) Internationale Veröffentlichungsnummer: WO 2009/074127

(56) Entgegenhaltungen:
- WO-A1-2005/114762
- DE-A1- 10 255 933
- DE-A1- 10 312 219
- US-A1- 2007 176 195
- US-A1- 2007 217 702
- US-A1- 2007 230 211

## Beschreibung

Die Erfindung betrifft lichtemittierende Vorrichtungen mit einer lichtemittierenden Schicht oder einem lichtemittierenden Element. Die Erfindung betrifft weiterhin Verfahren zur Herstellung solcher lichtemittierenden Vorrichtungen.

Lichtemittierende Vorrichtungen, wie beispielsweise eine OLED (organic light emitting diode), weisen üblicherweise ein Lambertsches Abstrahlungsprofil auf. Für Beleuchtungszwecke ist jedoch meist ein davon abweichendes, gerichtetes Abstrahlungsprofil geeigneter.

Die Druckschriften US 2007/176195A1 und WO 2005/114762A1 beschreiben lichtemittierende Vorrichtungen. Aufgabe der Erfindung ist es, eine lichtemittierende Vorrichtung zu schaffen, deren Abstrahlungsprofil von dem eines Lambertschen Strahlers abweicht.

Diese Aufgabe wird durch die lichtemittierenden Vorrichtungen gemäß den unabhängigen Ansprüchen gelöst. Vorteilhafte Ausgestaltungen und Weiterbildungen sind Gegenstand der jeweiligen abhängigen Ansprüche.

Eine erfindungsgemäße lichtemittierende Vorrichtung umfasst eine lichtemittierende Schicht, eine Lichtaustrittsschicht und ein transparentes Substrat. Die lichtemittierende Schicht ist innerhalb eines OLED-Schichtaufbaus angeordnet, wobei der OLED-Schichtaufbau weiter zwei Elektroden und eine oder mehrere Schichten, die der Injektion von Ladungsträgern in die lichtemittierende Schicht dienen, umfasst und wobei der OLED-Schichtaufbau auf einer Seite des Substrats angeordnet ist. Die Lichtaustrittsschicht weist eine Vielzahl von zueinander parallelen ersten Flächen auf, die geneigt zur lichtemittierende Schicht angeordnet sind. Die Lichtaustrittsschicht weist weiterhin eine Vielzahl von zueinander parallelen zweiten Flächen auf, die geneigt zur lichtemittierende Schicht und geneigt zu den ersten Flächen angeordnet sind. Die ersten Flächen sind transparent und die zweiten Flächen reflektierend für von der lichtemittierende Schicht emittiertes Licht. Die zweiten Flächen sind durch Bedampfen mit Metallpartikel reflektierend gemacht. Nur die ersten Flächen stellen Lichtaustrittsflächen dar, so dass ein Abstrahlungsprofil der Lichtaustrittsschicht eine Hauptstrahlungsrichtung aufweist, die nicht senkrecht zur lichtemittierenden Schicht ist. Die Lichtaustrittsschicht befindet sich auf der der lichtemittierenden Schicht abgewandten Seite des Substrats.

In erster Näherung weisen planare Lichtaustrittsschichten ein Lambertsches Abstrahlungsprofil mit einer Hauptstrahlungsrichtung senkrecht zur Lichtaustrittsfläche auf. Erfindungsgemäß stellen nur die ersten Flächen Lichtaustrittsflächen dar, wodurch das Abstrahlungsprofil eine Hauptstrahlungsrichtung aufweist, die nicht senkrecht zur lichtemittierenden Schicht und damit nicht senkrecht zu der Ebene ist, in der die lichtemittierende Vorrichtung flächig ausgebildet ist. Bezüglich dieser Ebene weicht das Abstrahlungsprofil von dem eines Lambertschen Strahlers ab.

In einer vorteilhaften Ausgestaltung weist die lichtemittierende Schicht der lichtemittierenden Vorrichtung ein organisches Material auf. Auf organischen Materialien basierende lichtemittierende Schichten lassen sich großflächig herstellen und sind daher besonders gut für lichtemittierende Vorrichtungen, die als Flächenstrahler ausgebildet sind.

In einer weiteren vorteilhaften Ausgestaltung der lichtemittierenden Vorrichtung weisen die ersten Flächen und die zweiten Flächen in jeder Richtung eine Ausdehnung auf, die größer als eine Wellenlänge des von der lichtemittierenden Schicht ausgestrahlten Lichts ist. Bevorzugt ist diese Ausdehnung jedoch kleiner als 1 mm und besonders bevorzugt kleiner als 100 µm.

In einer weiteren vorteilhaften Ausgestaltung der lichtemittierenden Vorrichtung ist eine von der lichtemittierenden Schicht abweisende Oberfläche der Lichtaustrittsschicht durch parallel angeordneten Prismen strukturiert, wobei die ersten Flächen und die zweiten Flächen durch Flächen der Prismen gebildet werden. Alternativ ist es auch möglich, eine von der lichtemittierenden Schicht abweisende Oberfläche der Lichtaustrittsschicht durch kegel- oder pyramiden- oder linsen- oder zylinderförmige Elemente zu strukturieren, wobei analog die ersten Flächen und die zweiten Flächen durch Flächen dieser Elemente gebildet werden.

Vorteilhafterweise kann die Lichtaustrittsschicht der lichtemittierenden Vorrichtung durch das Substrat oder eine Passivierungsschicht gebildet werden.

Eine lichtemittierende Vorrichtung gemäß eines zweiten, nicht zur Erfindung gehöhrenden Aspekts umfasst einen Träger und eine Mehrzahl lichtemittierender Elemente. Dabei weist der Träger eine Mehrzahl von zueinander parallelen ersten Flächen und eine Mehrzahl von zueinander parallelen zweiten Flächen, die geneigt zu den ersten Flächen angeordnet sind, auf. Die lichtemittierenden Elemente sind auf den ersten Flächen angeordnet. Erfindungsgemäß stellen somit nur die ersten Flächen lichtemittierende Flächen dar. Diese Flächen sind geneigt bezüglich der Ebene, in der die lichtemittierende Vorrichtung flächig ausgebildet ist. Dadurch weist das Abstrahlungsprofil eine Hauptstrahlungsrichtung auf, die nicht senkrecht zu der Ebene ist, in der die lichtemittierende Vorrichtung flächig ausgebildet ist. Bezüglich dieser Ebene weicht das Abstrahlungsprofil wie bei einer lichtemittierenden Vorrichtung gemäß dem ersten Aspekt der Erfindung von dem eines Lambertschen Strahlers ab.

Bevorzugt weisen lichtemittierenden Elemente eine OLED auf. Weiter ist bevorzugt, dass der Träger der lichtemittierenden Vorrichtung durch parallel angeordnete Prismen strukturiert ist, wobei die ersten Flächen und die zweiten Flächen durch Flächen der Prismen gebildet werden.

Eine lichtemittierende Vorrichtung gemäß eines dritten, nicht zur Erfindung gehörenden Aspekts umfasst ein Substrat und eine auf eine Oberfläche des Substrats aufgebrachte Schichtenfolge mit mindestens einer lichtemittierenden Schicht, wobei die Oberfläche des Substrats in einer lateralen Richtung periodisch höhenstrukturiert ist. Bei einer Vorrichtung gemäß diesem Aspekt übernimmt das höhenstrukturierte Substrat neben seiner Funktion als Substrat für eine lichtemittierende Schichtenfolge die Funktion oben genannten Trägers. Die lichtemittierende Vorrichtung weist somit eine lichtemittierende Fläche auf, die wie die Oberfläche des Substrats höhenstrukturiert ist. Die Höhenstrukturierung der Oberfläche kann so ausgeführt werden, dass Bereiche der Oberfläche geneigt zur Ebene der flächigen Ausdehnung der lichtemittierenden Vorrichtung sind. Entsprechend ergeben sich die Vorteile des zweiten Aspekts.

In einer vorteilhaften Ausgestaltung weist die lichtemittierende Schicht ein organisches Material auf.

In einer weiteren vorteilhaften Ausgestaltung der lichtemittierenden Vorrichtung ist die Höhenstrukturierung in der einen lateralen Richtung linear steigend und fallend und die Oberfläche des Substrats weist im Wesentlichen plane Flächen auf.

In einer weiteren vorteilhaften Ausgestaltung der lichtemittierenden Vorrichtung ist die Höhenstrukturierung in der einen lateralen Richtung nichtlinear steigend und/oder fallend und die Oberfläche des Substrats weist gebogene Flächen auf. Das Abstrahlungsprofil einer solchen lichtemittierenden Vorrichtung kann in weiten Grenzen eingestellt werden.

Bevorzugt kann das Substrat aus Kunststoff in einem Spritzgussverfahren hergestellt werden oder besteht aus Metall, das durch ein Prägeverfahren strukturiert ist.

Eine lichtemittierende Vorrichtung gemäß eines vierten, nicht zur Erfindung gehörenden Aspekts umfasst eine lichtemittierende Schicht, die in einer lateralen Richtung abwechselnd angeordnete streifenförmige erste Bereiche und zweite Bereiche aufweist, wobei die ersten Bereiche und die zweiten Bereiche verschiedene Brechungszahlen haben. Bei einer solchen lichtemittierenden Vorrichtung führen Beugungseffekte zu einem Abstrahlprofil, das von dem eines Lambertschen Strahlers abweicht.

Bevorzugt ist dabei die Abmessung der ersten Bereiche und der zweiten Bereiche in der lateralen Richtung von der Größenordnung einer Wellenlänge des von der lichtemittierenden Schicht ausgestrahlten Lichtes. Besonders bevorzugt ist sie kleiner als das 5-fache der Wellenlänge.

In einer vorteilhaften Ausgestaltung weist die lichtemittierenden Schicht ein organisches Material auf.

In einem Herstellungsverfahren für eine lichtemittierende Vorrichtung mit einer lichtemittierenden Schicht gemäß eines fünften, nicht zur Erfindung gehöhrenden Aspekts werden Bereiche der lichtemittierenden Schicht zur Veränderung des Brechungsindex in den Bereichen mit UV-Licht bestrahlt. Dieses Herstellungsverfahren ermöglicht die Herstellung einer lichtemittierenden Vorrichtung gemäß des vierten Aspekts. Es ist zur Herstellung großflächiger Vorrichtungen geeignet und fügt sich insbesondere gut in bekannte Herstellungsverfahren für flächige OLED ein.

Eine lichtemittierende Vorrichtung gemäß eines sechsten, nicht zur Erfindung gehörenden Aspekts umfasst eine lichtemittierende Schicht und eine Lichtaustrittsschicht, wobei in oder auf der Lichtaustrittsschicht eine Vielzahl von anisotropen Streupartikeln angeordnet ist, die entlang einer lateralen Richtung der lichtemittierenden Vorrichtung ausgerichtet sind. Die Ausrichtung der Streupartikel führt in Verbindung mit ihrer Anisotropie zu einer anisotropen Streuung des Lichtes beim Austritt aus der lichtemittierenden Vorrichtung. Dieses führt zu einer von dem Lambertschen Abstrahlungsprofil abweichenden Abstrahlungsprofil der lichtemittierenden Vorrichtung, wobei das Abstrahlprofil vom Streuverhalten und Grad der Anisotropie der Streupartikeln abhängt.

Bevorzugt weist die lichtemittierende Schicht ein organisches Material auf. Weiterhin ist bevorzugt, dass die Streupartikel bezüglich ihrer Abmessungen anisotrop sind und/oder bezüglich ihres Streuverhaltens.

Weiter ist bevorzugt, dass die Streupartikel ein von Null verschiedenes permanentes oder induzierbares elektrisches oder ein magnetisches Dipol- oder Quadrupolmoment aufweisen oder dass die Streupartikel selbstanordnende Moleküle sind oder in einer dehnbaren Folie angeordnet sind.

In einem Herstellungsverfahren für eine lichtemittierende Vorrichtung mit einer lichtemittierenden Schicht gemäß eines siebten, nicht zur Erfindung gehöhrenden Aspekts werden Streupartikel mit einem von Null verschiedenen permanenten oder induzierbaren elektrischen oder magnetischen Dipol- oder Quadrupolmoment in eine Lichtaustrittsschicht eingebracht und durch ein angelegtes elektrisches oder magnetisches Feld ausgerichtet. Dieses Herstellungsverfahren ermöglicht die Herstellung einer lichtemittierenden Vorrichtung gemäß dem vierten Aspekt.

Die Erfindung wird im Folgenden anhand von Ausführungsbeispielen mit Hilfe von 7 Figuren näher erläutert. Es zeigt:
Figur 1 eine dreidimensionale schematische Darstellung einer lichtemittierenden Vorrichtung,
Figur 2 verschiedene Abstrahlungsprofile von lichtemittierenden Vorrichtungen,
Figur 3 und Figur 4 weitere lichtemittierende Vorrichtungen, jeweils in einer dreidimensionalen schematischen Darstellung und einer Aufsicht,
Figur 5 drei weitere lichtemittierende Vorrichtungen im Querschnitt,
Figur 6 eine weitere lichtemittierende Vorrichtung im Querschnitt zu zwei verschiedenen Zeitpunkten ihres Herstellungsprozesses und
Figur 7 eine Aufsicht auf eine weitere lichtemittierende Vorrichtung.

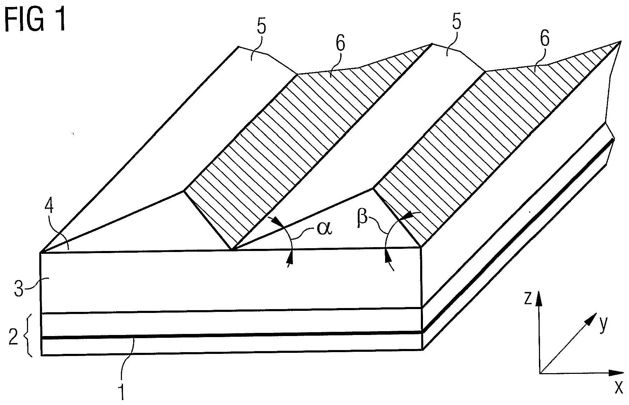

In Figur 1 ist ein erstes Ausführungsbeispiel einer lichtemittierenden Vorrichtung in einer dreidimensionalen Schemazeichnung dargestellt.

Eine lichtemittierende Schicht 1 ist innerhalb eines OLED (organic light emitting diode) -Schichtaufbaus 2 angeordnet. Der OLED-Schichtaufbau 2 befindet sich auf einer ersten Seite eines flächigen Substrats 3. Auf der dem OLED-Schichtaufbau 2 gegenüberliegenden Seite des Substrats 3 ist eine Lichtaustrittsschicht 4 vorgesehen. Auf der dem Substrat 3 abgewandten Seite weist die Lichtaustrittsschicht 4 eine Vielzahl von ersten Flächen 5 auf, die um einen Winkel α gegenüber dem Substrat 3 geneigt sind, sowie eine Vielzahl von zweiten Flächen 6, die um einen Winkel β gegenüber dem Substrat 3 geneigt sind.

Die lichtemittierende Vorrichtung der Figur 1 ist als eine "bottom emission" OLED ausgeführt. Das Substrat 3 ist bei einer solchen Ausführungsform transparent, sodass das von der lichtemittierenden Schicht 1 emittierte Licht durch das Substrat 3 zur Lichtaustrittsschicht 4 gelangt. Alternativ ist eine Ausführung als "top emission" OLED möglich, bei der der OLED-Schichtaufbau 2 auf ein nichttransparentes Substrat aufgebracht wird. Auf der dem nichttransparenten Substrat abgewandten Seite des OLED-Schichtaufbaus 2 ist dann anstelle des in der Figur 1 gezeigten transparenten Substrats 3 eine transparente Passivierungsschicht vorgesehen. Alle in der Anmeldung beschriebenen Ausführungsbeispiele einer lichtemittierenden Vorrichtung können durch eine entsprechende Modifikation entweder auf Basis einer "bottom emission" oder einer "top emission" OLED aufgebaut werden.

Der OLED-Schichtaufbau 2 umfasst neben der lichtemittierenden Schicht 1 mindestens eine erste und eine zweite Elektrode und eine oder mehrere Schichten, die der Injektion von Ladungsträgern in die lichtemittierende Schicht 1 dienen und diese so im Betrieb zum Leuchten anregen. Die Elektrodenschichten können beispielsweise aus transparenten leitenden Materialien wie etwa Indium-Zinn-Oxid (ITO) oder Indium-Zink-Oxid, Zink-Oxid oder Zinn-Oxid gebildet werden.

Die lichtemittierende Schicht 1 weist ein organisches material als optisch aktives, strahlungserzeugendes Material auf. Dieses kann beispielsweise ein organisches Material mit geringem Molekulargewicht, auch kleinmoleküliges organisches Material genannt, ein Polymer oder eine Kombination dieser beiden Materialien sein.

Kleinmolekülige organische Materialien werden typischerweise durch thermisches Verdampfen unter Vakuumbedingungen aufgebracht. Beispiele für strahlungserzeugende kleinmolekülige organische Materialien sind Tris(8-hydroxychinolinato)aluminium (Alq), 1,3-Bis(N,N-dimethylaminophenyl)-1,3,4-oxidazol (OXD-8), Oxo-bis(2-methyl-8-chinolinato)aluminium, Bis(2-methyl-8-hydroxychinolinato)aluminium; Bis(hydroxybenzochinolinato)beryllium (BeQ.sub.2), Bis(diphenylvinyl)biphenylen (DPVBI) und Arylaminsubstituiertes Distyrylarylen (DSA-Amin).

Polymere werden üblicherweise durch ein Aufschleuderverfahren, auch Spincasting oder Spincoating genannt, aufgetragen. Alternativ kann auch ein räumlich selektives Abscheiden erfolgen, z.B. durch Tintenstrahldrucken. Beispiele für strahlungserzeugende Polymere sind Poly(p-phenylenvinylen) und Polyarylenvinylen sowie Copolymere von Arylen-Vinylen-Oligomeren, Polyarylene, Polychinolin sowie jeweils deren Derivate und Mischungen.

Die Lichtaustrittsschicht 4 ist eine auf das Substrat 3 aufgebrachte Schicht, die eine Vielzahl von parallel zueinander angeordneten Prismen aufweist, wobei die ersten Flächen 5 und die zweiten Flächen 6, die der OLED-Schichtfolge 2 abgewandte Oberfläche der lichtemittierenden Vorrichtung bilden. Aus Gründen der Übersichtlichkeit sind in der Figur 1 nur jeweils zwei der Vielzahl von ersten Flächen 5 und zweiten Flächen 6 dargestellt.

Weder die ersten Flächen 5 noch die zweiten Flächen 6 sind parallel zur lichtemittierenden Schicht 1 angeordnet. Somit sind sie auch nicht parallel zu der Ebene, in der die lichtemittierende Vorrichtung flächig ausgebildet ist. In allen gezeigten Ausführungsbeispielen wird diese Ebene, in der die lichtemittierende Vorrichtung flächig ausgebildet ist, als XY-Ebene definiert.

Die Ausdehnung der Prismen in Y-Richtung (Länge) liegt dabei bevorzugt in makroskopischen Größenordnungen, also beispielsweise im Bereich von Millimetern bis Dezimetern. Bevorzugt wird die gesamte Oberfläche der lichtemittierenden Vorrichtung von in Y-Richtung durchgängigen Prismen bedeckt. Die Breite der Prismen in X-Richtung ist bevorzugt größer als die Wellenlänge des emittierten Lichts, sodass Beugungseffekte an den Prismen sich nicht bemerkbar machen. Die Breite liegt bevorzugt jedoch in mikroskopischen Größenordnungen, beispielsweise im Submillimeterbereich, sodass aus einem normalen Betrachterabstand der lichtemittierenden Vorrichtung die Strukturierung in X-Richtung nicht sichtbar ist.

Die ersten Flächen 5 der Lichtaustrittsschicht 4 sind transparent, wohingegen die zweiten Flächen 6 reflektierend für von der lichtemittierenden Schicht 1 abgestrahltes Licht sind. Die zweiten Flächen 6 können beispielsweise durch Bedampfen mit Metallpartikeln unter einem sehr flachen Einfallswinkel reflektierend gemacht werden.

In erster Näherung ergibt sich bei einer OLED mit einer planaren, parallel zu der lichtemittierenden Schicht angeordneten Lichtaustrittsschicht ein Lambertsches Abstrahlungsprofil mit einer Hauptstrahlungsrichtung senkrecht zur Lichtaustrittsfläche. Im gezeigten Ausführungsbeispiel stellen nur die ersten Flächen 5 Lichtaustrittsflächen dar, wodurch das Abstrahlungsprofil eine Hauptstrahlungsrichtung aufweist, die gegenüber der Z-Achse in Richtung der X-Achse geneigt ist. Der Neigungswinkel der Hauptstrahlungsrichtung der lichtemittierenden Vorrichtung wird dabei im Wesentlichen vom Winkel α bestimmt. Von der lichtemittierenden Schicht 1 ausgestrahltes Licht, das von den zweiten Flächen 6 reflektiert wird, kann nach einer oder mehreren internen Reflexionen ebenfalls durch die transparenten ersten Flächen 5 aus der lichtemittierenden Vorrichtung austreten. Der Winkel β beeinflusst dabei sowohl die Winkelverteilung des abgestrahlten Lichtes als auch die Häufigkeit interner Reflexionen. Durch geeignete Wahl des Winkels β kann die Gesamtintensität und damit die Effizienz der lichtemittierenden Vorrichtung optimiert werden.

Im gezeigten Ausführungsbeispiel ist die Strukturierung der separaten Lichtaustrittsschicht 4 vorgesehen. Die Lichtaustrittsschicht 4 kann in dem Fall eine entsprechend strukturierte Folie sein, die auf das Substrat 3 aufgebracht wird. Es ist auch möglich, auf eine separate Lichtaustrittsschicht 4 zu verzichten, in dem die Oberfläche des Substrats 3 selbst strukturiert wird.

Neben der dargestellten Strukturierung in Form von parallelen Prismen mit jeweils planaren ersten Flächen 5 und zweiten Flächen 6 ist auch eine Strukturierung mit nicht planaren Flächen denkbar, beispielsweise mit Zylinderflächen. Auch eine Strukturierung durch pyramiden-, kegel- oder linsenförmige Elemente beziehungsweise Flächenabschnitte ist denkbar.

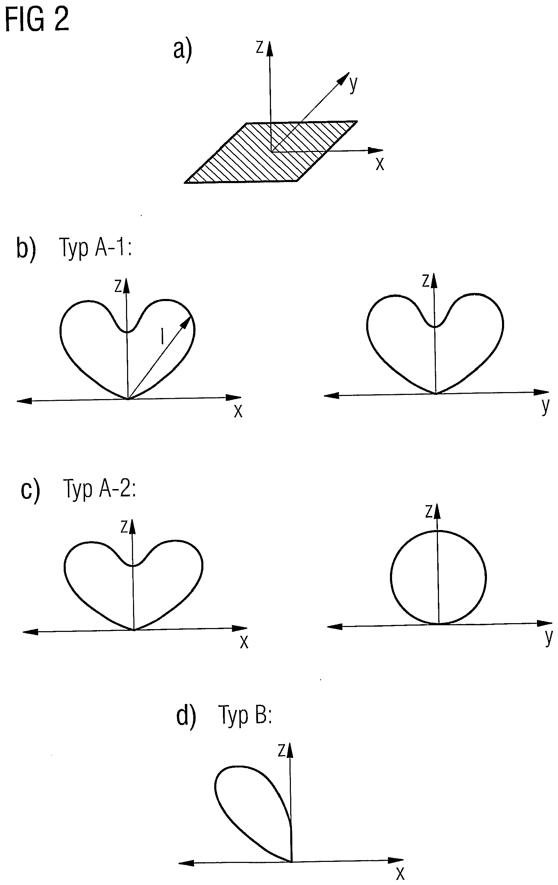

In Figur 2 sind verschiedene Abstrahlungsprofile (winkelabhängige Verteilung der abgestrahlten Intensität) der erfindungsgemäßen lichtemittierenden Vorrichtungen dargestellt.

In Figur 2a ist zunächst das zugrunde liegende Koordinatensystem angegeben. Die lichtemittierende Vorrichtung bildet mit ihrer lateralen flächigen Ausdehnung die XY-Ebene des Koordinatensystems. Bekannte OLED-Strukturen mit einer ebenen, parallel zur lichtemittierenden Schicht angeordneten Lichtaustrittsfläche zeigen ein Lambertsches Abstrahlungsprofil in Richtung der Z-Achse. Für Beleuchtungszwecke sind jedoch häufig davon abweichende Abstrahlungsprofile gewünscht. Geeignete Abstrahlungsprofile sind in den Figuren 2b bis 2d dargestellt.

Die in den Figuren 2b und 2c gezeigten, Typ A-1 und Typ A-2 genannten Abstrahlungsprofile zeichnen sich durch eine symmetrische herzförmige Strahlungsrichtungsverteilung mit zwei Maxima sowohl in X- als auch in Y-Richtung (Typ A-1) oder in eine der beiden Richtungen (Typ A-2) aus. Diese Abstrahlungsmuster sind für allgemeine Beleuchtungszwecke in Räumen geeignet.

Das in Figur 2d gezeigte Profil, Typ B genannt, ist stark asymmetrisch in zumindest einer der Richtungen X und Y und ist insbesondere für Signalisierungsanwendungen geeignet, zum Beispiel zur Kennzeichnung von Stufen in einer abgedunkelten Umgebung oder zur Realisierung von blendfreien flächigen Wandleuchten.

Mit der in Figur 1 gezeigten lichtemittierenden Vorrichtung lässt sich ein Abstrahlungsmuster des Typs B realisieren.

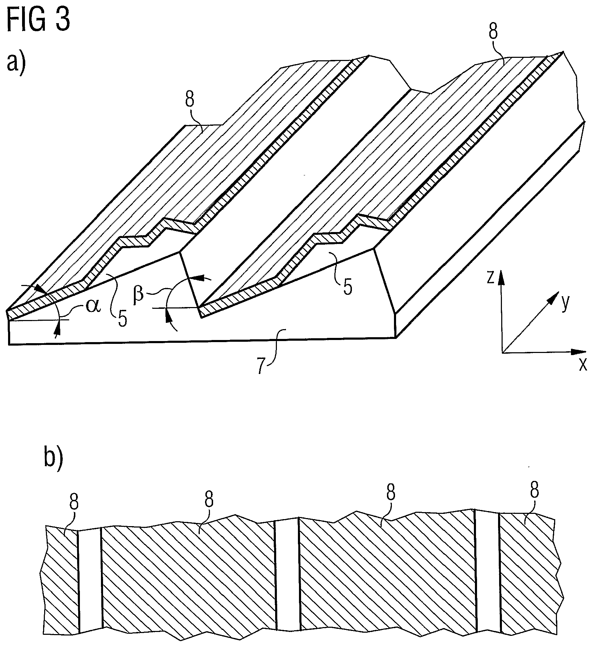

In Figur 3 ist ein weiteres, nicht zur Erfindung gehörendes Beispiel einer lichtemittierenden Vorrichtung in einer perspektivischen Ansicht (Figur 3a) und einer Aufsicht (Figur 3b) dargestellt.

Die Oberfläche eines Trägers 7 ist in Form einer Mehrzahl von parallel angeordneten Prismen mit ersten Flächen 5 und zweiten Flächen 6 strukturiert. Die laterale flächige Ausdehnung der lichtemittierenden Vorrichtung und des Trägers 7 liegt in der XY-Ebene. Gegenüber dieser XY-Ebene sind die ersten Flächen 5 um den Winkel α und die zweiten Flächen 7 um den Winkel β geneigt. Auf den ersten Flächen 5 sind Leuchtelemente 8 angeordnet.

Bezüglich seiner Oberfläche ist der Träger 7 vergleichbar strukturiert wie die Lichtaustrittsfläche 4 in dem in Figur 1 gezeigten Ausführungsbeispiel. Gefertigt sein kann der Träger 7 beispielsweise aus Kunststoff, wobei die Strukturierung seiner Oberfläche bevorzugt durch ein Spritzguss- oder ein Tiefziehverfahren erreicht wird. Weiterhin ist möglich, den Träger 7 aus einer Metallfolie oder einem Metallblech herzustellen, das durch ein Prägeverfahren strukturiert wird.

Die Leuchtelemente 8 sind unabhängig vom Träger 7 funktionsfähige Elemente. Sie können zum Beispiel jeweils ein Substrat und einen OLED-Schichtaufbau mit mindestens einer lichtemittierenden Schicht umfassen. Bezüglich des Aufbaus und der Materialien des OLED-Schichtaufbau und der lichtemittierenden Schicht wird auf das im Zusammenhang mit dem Ausführungsbeispiel der Figur 1 gesagte verwiesen.

Ähnlich zu dem in Figur 1 dargestellten Ausführungsbeispiel stellt sich auch bei dem Beispiel der Figur 3 eine Abstrahlcharakteristik ein, deren Hauptstrahlungsrichtung im Wesentlichen um den Winkel α gegenüber der Z-Richtung geneigt ist. Das Abstrahlungsmuster ist ebenfalls vom Typ B.

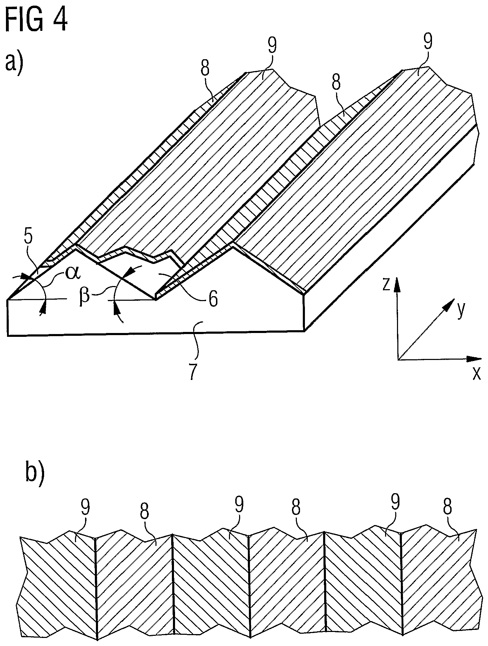

Ein weiteres, nicht zur Erfindung gehörendes Beispiel einer lichtemittierenden Vorrichtung ist in Figur 4 wiederum in einer perspektivischen Ansicht (Figur 4a) und einer Aufsicht (Figur 4b) dargestellt. Wie bei dem in Figur 3 gezeigten Beispiel ist ein Träger 7 vorgesehen, dessen Oberfläche in Form von parallelen Prismen strukturiert ist. Im Unterschied zum Beispiel der Figur 3 sind nicht nur die ersten Flächen 5 mit Leuchtelementen 8, sondern auch die zweiten Flächen 6 mit Leuchtelementen 9 belegt.

Beim Beispiel der Figur 4 ist die Oberfläche des Trägers 7 in Form von Prismen strukturiert, die den Querschnitt eines gleichschenkligen Dreiecks aufweisen. Die gezeigte Anordnung resultiert in einer symmetrischen Abstrahlcharakteristik vom Typ A-2, mit zwei Hauptstrahlungsrichtungen, die von der Z-Achse um den Winkel α = β in positive und negative X-Richtung geneigt sind. In Y-Richtung ergibt sich bei ausreichender Ausdehnung der lichtemittierenden Vorrichtung ein in erster Näherung Lambertsches Abstrahlungsprofil. Falls die Winkel α und β nicht gleich gewählt werden, sind die beiden Hauptstrahlungsrichtungen um unterschiedliche Winkel von der Z-Richtung geneigt. Gleichzeitig ist die Intensität, mit der in die Hauptstrahlungsrichtungen emittiert wird, aufgrund der sich ergebenden unterschiedlich großen Flächen der Leuchtelemente 8 und Leuchtelemente 9 verschieden.

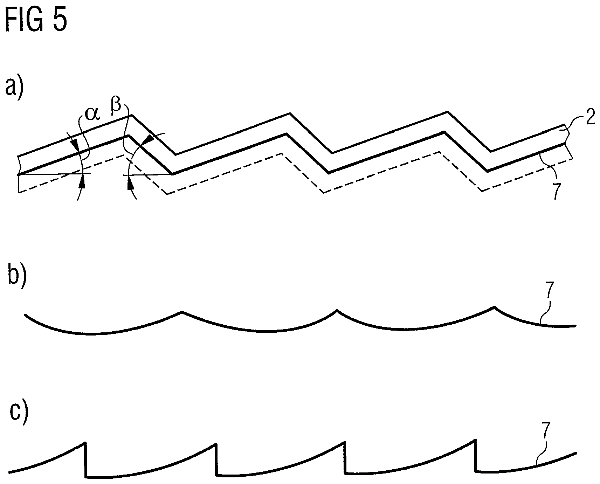

Eine weitere lichtemittierende Vorrichtung ist in der Figur 5a im Querschnitt dargestellt.

Auf einem Substrat 3, dessen Oberfläche durch parallel angeordnete Prismen strukturiert ist, ist ein OLED-Schichtaufbau 2 aufgebracht. Gleiche Bezugszeichen in den Figuren bezeichnen gleiche oder gleich wirkende Elemente.

Im Unterschied zu den in Figur 3 beziehungsweise 4 gezeigten Beispielen übernimmt beim nicht zur Erfindung gehörendem Beispiel der Figur 5a das Substrat 3 auch die Funktion des Trägers 7. Daraus ergibt sich, dass nicht separate, ein Substrat aufweisende Leuchtelemente eingesetzt werden, sondern der OLED-Schichtaufbau 2 unmittelbar auf das strukturierte Substrat aufgebracht wird. Bezüglich des Aufbaus und der Materialien des OLED-Schichtaufbau und einer darin enthaltenen lichtemittierenden Schicht wird wiederum auf die Ausführungen im Zusammenhang mit dem Ausführungsbeispiel der Figur 1 verwiesen.

Im gezeigten Beispiel sind die Winkel α und β unterschiedlich groß gewählt. Es ergibt sich eine Verteilung vom Typ A-2 mit unterschiedlichen Intensitäten in beiden Hauptstrahlungsrichtungen. Das Substrat 3 kann zum Beispiel aus Kunststoff hergestellt werden, dass durch einen Spritzguss- oder durch ein Tiefziehverfahren entsprechend strukturiert ist. Falls die lichtemittierende Vorrichtung in Form einer "bottom emitter" OLED aufgebaut wird, bei dem die Strahlung durch das Substrat 3 austritt, ist zum Erreichen einer entsprechenden Abstrahlcharakteristik notwendig, auch die dem OLED-Schichtaufbau 2 gegenüberliegende Oberfläche des Substrats 3 entsprechend zu strukturieren. In der Figur 5a ist das durch die gestrichelte Linie angedeutet. Falls die lichtemittierende Vorrichtung dagegen als "top emitter" OLED aufgebaut wird, kann die der OLED gegenüberliegende Seite des Substrats eine beliebige Formgebung annehmen, zum Beispiel planar sein. Im Fall einer "top emitter" OLED kann das Substrat 3 auch nichttransparent sein und beispielsweise von einer Metallfolie oder einem Metallblech gebildet werden, in das die entsprechende Oberflächenstrukturierung eingeprägt ist.

In den Figuren 5b und 5c sind weitere Oberflächenstrukturierungen für lichtemittierende Vorrichtungen gezeigt, die im Zusammenhang mit dem in Figur 5a dargestellten Beispiel eingesetzt werden können.

Insbesondere ist festzuhalten, dass die Oberfläche des Substrats 3 nicht zwingend aus verschiedenen planaren Flächen zusammengesetzt sein muss, sondern auch krummlinig begrenzte Flächen aufweisen kann. Durch die gewählte Formgebung der Oberfläche kann die Abstrahlcharakteristik in X-Richtung in weiten Grenzen variiert werden. Beispielsweise resultiert die in Figur 5b gezeigte Geometrie in einer Intensitätsverteilung vom Typ A-2. Die Verteilung ist dabei symmetrisch zur Z-Achse und je nach Krümmungsradius und Tiefe der die Oberfläche bildenden Zylinderabschnitte kann erreicht werden, dass sich zwei voneinander getrennte Hauptstrahlungsrichtungen, von der Z-Achse geneigt in die Richtung der positiven beziehungsweise negativen X-Achse, ergeben oder eine Hauptstrahlungsrichtung in Richtung der Z-Achse, wobei das Abstrahlungsprofil gegenüber einer Lambertschen Abstrahlungsprofil jedoch keulenartig gerichtet ist. Mit einer Oberflächengeometrie wie in Figur 5c gezeigt, kann eine Abstrahlungscharakteristik vom Typ B erreicht werden.

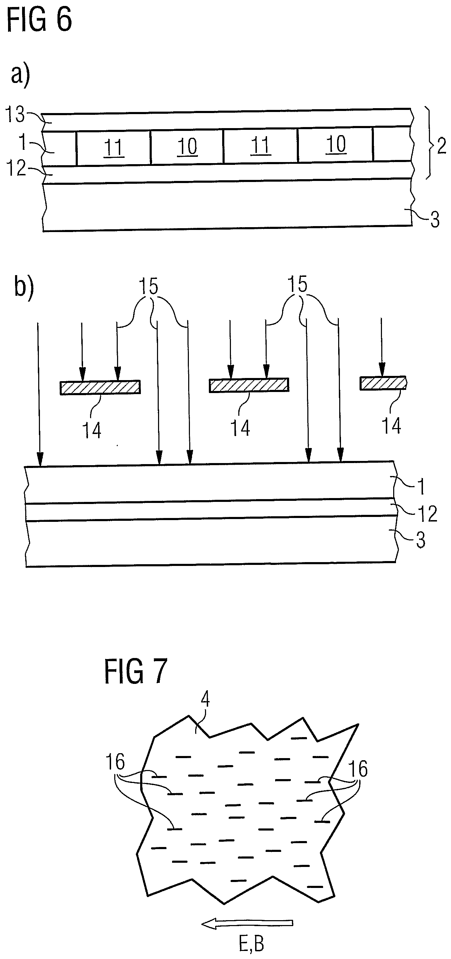

In Figur 6a ist der Querschnitt einer weiteren, nicht zur Erfindung gehörenden lichtemittierenden Vorrichtung gezeigt.

Auf einem Substrat 3 ist ein OLED-Schichtaufbau 2 angeordnet. Dieser weist eine dem Substrat 3 zugewandte erste Elektrode 12, eine lichtemittierende Schicht 1 und abschließend eine zweite Elektrode 13 auf. Die lichtemittierende Schicht 1 weist dabei alternierend in die Bildebene hinein verlaufende streifenförmige erste Bereiche 10 und zweite Bereiche 11 auf. Der OLED-Schichtaufbau 2 kann weitere, hier nicht gezeigte Schichten umfassen. Wiederum wird bezüglich seines Aufbaus und geeigneter Materialien auf die Ausführungen zu Figur 1 verwiesen.

Bei dem Beispiel der Figur 6a wird eine Änderung der Abstrahlcharakteristik der lichtemittierenden Vorrichtung nicht wie bei den zuvor gezeigten Beispielen durch die Ausrichtung der Lichtaustrittsflächen erreicht, sondern durch eine Beugung des Lichts innerhalb der lichtemittierenden Schicht 1. Zu diesem Zweck ist die lichtemittierende Schicht 1 durch die verschiedenen streifenförmigen ersten Bereiche 10 und zweiten Bereiche 11 strukturiert, wobei sich die beiden Bereiche 10 beziehungsweise 11 durch ihre Brechungszahl unterscheiden. Da in diesem Beispiel im Gegensatz zu den zuvor gezeigten Beispielen Beugungseffekte des Lichts bedeutsam ist, sind die Abmessungen der ersten Bereiche 10 und zweiten Bereiche 11 in X-Richtung (Streifenbreite) von der Größenordnung des von der lichtemittierenden Schicht 1 ausgestrahlten Lichtes. Die entstehenden Beugungserscheinungen sind mit der Beugung an einem Gitter vergleichbar. Innerhalb der Kavität, die durch innere und/oder äußere Grenzflächen der lichtemittierenden Vorrichtung geformt wird, bildet sich ein Intensitätsmuster aus, das gegenüber einer Vorrichtung mit einer homogenen lichtemittierenden Schicht 1 größere Intensitätsanteile parallel zur X-Achse aufweist. Entsprechend verändert sich das Abstrahlungsprofil der lichtemittierenden Vorrichtung von dem eines Lambertschen Strahlers zu einem Strahler vom Typ A-2.

In Figur 6b ist dargestellt, wie die Strukturierung der lichtemittierenden Schicht 1 während des Herstellungsprozesses erfolgen kann. Die zum Zeitpunkt der Strukturierung der lichtemittierenden Schicht 1 das Substrat 3, die erste Elektrode 10 und die lichtemittierende Schicht 1 umfassende lichtemittierende Vorrichtung wird durch eine Maske 14 mit UV-Licht 15 bestrahlt. Dort wo die UV-Strahlung 15 auf die lichtemittierende Schicht 1 auftrifft, wird deren Struktur auf molekularer Ebene verändert, beispielsweise durch eine Veränderung des Polymerisierungsgrades eines organischen Polymers in der lichtemittierenden Schicht 1. Mit der veränderten Molekularstruktur gehr eine Änderung der Brechungszahl einher.

Figur 7 zeigt eine weitere, nicht zur Erfindung gehörende lichtemittierende Vorrichtung in der Aufsicht. Bei diesem Beispiel sind auf oder in einer Lichtaustrittsschicht 4, durch die das Licht einer lichtemittierenden Schicht austritt, Streupartikel 16 angeordnet.

Streupartikel sind transparente oder nichttransparente Partikel, deren Größenordnung im Bereich von einigen µm bis einigen 10 µm liegen kann. Die Partikel können innerhalb der Lichtaustrittsschicht 4 angeordnet sein oder auch ganz oder teilweise aus dieser Schicht herausragen. Die Lichtaustrittsschicht 4 kann dabei eine planare, parallel zu einem Substrat und einem OLED-Schichtaufbau liegende Schicht sein. Die Lichtaustrittsschicht 4 kann auch durch ein Substrats oder eine Passivierungsschicht für den OLED-Schichtstapel realisiert sein.

Die Streupartikel 16 zeichnen sich durch ein permanentes oder induzierbares elektrisches oder magnetisches, von Null verschiedenes Dipol- oder Quadropolmoment aus, durch das eine Hauptachse der Streupartikel definiert wird. Durch ein während des Herstellungsprozesses angelegtes elektrisches (E) und/oder magnetisches (B) ausgerichtetes Feld, in der Figur 7 durch einen Vektorpfeil symbolisiert, werden die Streupartikel 16 bezüglich ihrer Hauptachse entlang einer vorgegebenen Richtung, hier der X-Achse, ausgerichtet. Beispielsweise ist es möglich, die Streupartikel in eine polymere Schicht einzubringen und vor dem Aushärten der Schicht entsprechend auszurichten. Die auf diese Weise eingefrorene Ausrichtung bleibt folglich auch ohne das ausrichtende elektrische und/oder magnetische Feld bestehen.

Weiterhin zeichnen sich die Streupartikel 16 durch eine Anisotropie in ihrer Geometrie und/oder in ihrem Brechungsindex aus, sodass relativ zur Orientierung ihrer Hauptachse ein anisotropes Streuverhalten für von der lichtemittierenden Schicht ausgestrahltes Licht zu beobachten ist. Die Anisotropie in der Geometrie und/oder dem Brechungsindex der ausgerichteten Streupartikel 16 bedingt eine anisotrope Streuung des Lichtes beim Austritt aus der lichtemittierenden Vorrichtung. Je nach Streuverhalten und Grad der Anisotropie führt dieses zu einer von dem Lambertschen Abstrahlungsprofil abweichenden Abstrahlungsprofil der lichtemittierenden Vorrichtung vom Typ A-1, A-2 oder B.

Auch Streupartikel, die kein von Null verschiedenes Dipol- oder Quadrupolmoment aufweisen, können ausgerichtet werden. Zum Beispiel können als Streupartikel 16 selbstanordnende Moleküle (self assembling molecules) eingesetzt werden, die sich während des Herstellungsprozesses unter geeigneten Bedingungen selbst ausrichten. Drüber hinaus ist es möglich, Streupartikel 16, insbesondere solche, die eine geometrische Anisotropie aufweisen, in eine dehnbare Folie einzubetten und durch Dehnen der Folie entlang einer Richtung auszurichten.

Die Erläuterung der Erfindung anhand der Ausführungsbeispiele ist nicht als Beschränkung der Erfindung hierauf zu verstehen. Die Erfindung bezieht sich vielmehr auf sämtliche Anordnungen mit den in den Ansprüchen genannten Merkmalen. Weiterhin umfasst die Erfindung sämtliche in der Beschreibung genannten Merkmale sowie deren Kombination, auch wenn diese nicht in den Ansprüchen oder der Beschreibung explizit genannt sind.

## Patentansprüche

1. Lichtemittierende Vorrichtung, umfassend
- eine lichtemittierende Schicht (1),
- eine Lichtaustrittsschicht (4) und
- ein transparentes Substrat (3),
wobei die lichtemittierende Schicht (1) innerhalb eines OLED-Schichtaufbaus (2) angeordnet ist, wobei der OLED-Schichtaufbau (2) weiter zwei Elektroden und eine oder mehrere Schichten, die der Injektion von Ladungsträgern in die lichtemittierende Schicht (1) dienen, umfasst und wobei der OLED-Schichtaufbau (2) auf einer Seite des Substrats (3) angeordnet ist,
wobei die Lichtaustrittsschicht (4)
- eine Vielzahl von zueinander parallelen ersten Flächen (5), die geneigt zur lichtemittierenden Schicht (1) angeordnet sind, und
- eine Vielzahl von zueinander parallelen zweiten Flächen (6), die geneigt zur lichtemittierenden Schicht (1) und geneigt zu den ersten Flächen (5) angeordnet sind,
aufweist, wobei
- die ersten Flächen (5) transparent und die zweiten Flächen (6) reflektierend für von der lichtemittierenden Schicht (1) emittiertes Licht sind,
- die zweiten Flächen (6) durch Bedampfen mit Metallpartikel reflektierend gemacht sind, und
- nur die ersten Flächen (5) Lichtaustrittsflächen darstellen, so dass ein Abstrahlungsprofil der Lichtaustrittsschicht (4) eine Hauptstrahlungsrichtung aufweist, die nicht senkrecht zur lichtemittierenden Schicht (1) ist,
- die Lichtaustrittsschicht (4) sich auf der der lichtemittierenden Schicht (1) abgewandten Seite des Substrats (3) befindet.

2. Lichtemittierende Vorrichtung nach Anspruch 1, bei der die ersten Flächen (5) und die zweiten Flächen (6) in jeder Richtung eine Ausdehnung aufweisen, die größer als eine Wellenlänge des von der lichtemittierenden Schicht (1) ausgestrahlten Lichts ist.

3. Lichtemittierende Vorrichtung nach Anspruch 2, bei der die Ausdehnung kleiner als 1 mm ist.

4. Lichtemittierende Vorrichtung nach Anspruch 3, bei der die Ausdehnung kleiner als 100 µm ist.

5. Lichtemittierende Vorrichtung nach einem der Ansprüche 1 oder 2, bei der eine von der lichtemittierenden Schicht (1) abweisende Oberfläche der Lichtaustrittsschicht (4) durch parallel angeordnete Prismen oder durch pyramidenförmige Elemente strukturiert ist, wobei die ersten Flächen (5) und die zweiten Flächen (6) durch Flächen dieser Elemente gebildet werden.

6. Lichtemittierende Vorrichtung nach einem der Ansprüche 1 bis 5, bei der die Lichtaustrittsschicht (4) durch das Substrat (3) oder eine Passivierungsschicht gebildet wird.

7. Lichtemittierende Vorrichtung nach einem der Ansprüche 1 bis 6, bei der die lichtemittierende Schicht (1) ein organisches Material aufweist.

## Claims

1. A light-emitting device, comprising
- a light-emitting layer (1),
- a light exit layer (4) and
- a transparent substrate (3),
wherein the light-emitting layer (1) is arranged within an OLED layer structure (2), wherein the OLED layer structure (2) further comprises two electrodes and one or more layers, the purpose of which is to inject charge carriers into the light-emitting layer (1), and wherein the OLED layer structure (2) is arranged on a side of the substrate (3),
wherein the light exit layer (4) comprises
- a plurality of first surfaces (5) parallel to one another, which are arranged obliquely relative to the light-emitting layer (1), and
- a plurality of second surfaces (6) parallel to one another, which are arranged obliquely relative to the light-emitting layer (1) and obliquely relative to the first surfaces (5), wherein
- the first surfaces (5) are transparent and the second surfaces (6) are reflective for light emitted by the light-emitting layer (1),
- the second surfaces (6) are made reflective by vapor deposition with metal particles, and
- only the first surfaces (5) represent light exit surfaces, so that a radiation profile of the light exit layer (4) has a main radiation direction which is not perpendicular to the light-emitting layer (1),
- the light exit layer (4) is located on the side of the substrate (3) facing away from the light-emitting layer (1).

2. The light-emitting device according to claim 1, in which the first surfaces (5) and the second surfaces (6) have in each direction an extension which is greater than a wavelength of the light emitted by the light-emitting layer (1).

3. The light-emitting device according to claim 2, in which the extension is less than 1 mm.

4. The light-emitting device according to claim 3, in which the extension is less than 100 µm.

5. The light-emitting device according to one of claims 1 or 2, in which a surface of the light exit layer (4) facing away from the light-emitting layer (1) is patterned by prisms arranged in parallel or by pyramid-shaped elements, wherein the first surfaces (5) and the second surfaces (6) are formed by surfaces of these elements.

6. The light-emitting device according to one of claims 1 to 5, in which the light exit layer (4) is formed by the substrate (3) or a passivation layer.

7. The light-emitting device according to one of claims 1 to 6, in which the light-emitting layer (1) comprises an organic material.

## Revendications

1. Dispositif émettant de la lumière, comprenant
- une couche (1) émettrice de lumière,
- une couche (4) de sortie de lumière et
- un substrat(3) transparent,
la couche (1) émettrice de lumière étant disposée à l'intérieur d'une structure de couches OLED (2), la structure de couches OLED (2) comprenant en outre deux électrodes et une ou plusieurs couches qui servent à l'injection de porteurs de charge dans la couche (1) émettrice de lumière, et la structure de couches OLED (2) étant disposée sur un côté du substrat (3),
la couche (4) de sortie de lumière présentant
- une pluralité de premières surfaces (5) parallèles les unes aux autres, lesquelles sont disposées de manière inclinée par rapport à la couche (1) émettrice de lumière, et
- une pluralité de deuxième surfaces (6), parallèles les unes aux autres, lesquelles sont disposées de manière inclinée par rapport à la couche (1) émettrice de lumière et de manière inclinée par rapport aux premières surfaces (5),
- les premières surfaces (5) étant transparentes et les deuxièmes surfaces (6) étant réfléchissantes pour la lumière émise par la couche (1) émettrice de lumière,
- les deuxièmes surfaces (6) étant rendues réfléchissantes par vaporisation avec des particules de métal, et
- seulement les premières surfaces (5) représentant des surfaces de sortie de lumière, de sorte qu'un profil de rayonnement de la couche (4) de sortie de lumière présente une direction de rayonnement principal qui n'est pas perpendiculaire à la couche (1) émettrice de lumière,
- la couche de sortie de lumière (4) se trouvant sur le côté du substrat (3) détourné de la couche (1) émettrice de lumière.

2. Dispositif émettant de la lumière selon la revendication 1, dans lequel les premières surfaces (5) et les deuxièmes surfaces (6) présentent dans chaque direction une étendue qui est plus grande qu'une longueur d'onde de la lumière émise par la couche (1) émettrice de lumière.

3. Dispositif émettant de la lumière selon la revendication 2, dans lequel l'étendue est plus petite que 1 mm.

4. Dispositif émettant de la lumière selon la revendication 3, dans lequel l'étendue est plus petite que 100 µm.

5. Dispositif émettant de la lumière selon l'une quelconque des revendications 1 ou 2, dans lequel une surface de la couche de sortie de lumière (4), réfléchissante par la couche (1) émettrice de lumière, est structurée par des prismes disposés parallèlement ou par des éléments en forme de pyramide, les premières surfaces (5) et les deuxièmes surfaces (6) étant formées par des surfaces de ces éléments.

6. Dispositif émettant de la lumière selon l'une quelconque des revendications 1 à 5, dans lequel la couche (4) de sortie de lumière est formée par le substrat (3) ou par une couche de passivation.

7. Dispositif émettant de la lumière selon l'une quelconque des revendications 1 à 6, dans lequel la couche (1) émettrice de lumière présente une matière organique.
